Europäisches Patentamt

European Patent Office

Office européen des brevets

(11) Publication number: **0 265 958**
**A2**

(12) **EUROPEAN PATENT APPLICATION**

(21) Application number: **87115933.1**

(22) Date of filing: **29.10.87**

(51) Int. Cl.4: **H01L 21/225** , H01L 21/28

(30) Priority: **30.10.86 IT 2218286**

(43) Date of publication of application:
**04.05.88 Bulletin 88/18**

(84) Designated Contracting States:
**DE FR GB NL SE**

(71) Applicant: SGS Microelettronica SpA
Via C. Olivetti, 2
I-20041 Agrate Brianza (MI)(IT)

(72) Inventor: Meda, Laura, Dr.
Via Panizza 11
I-20144 Milano(IT)
Inventor: Polignano, Maria Luisa, Dr.
Viale Casiraghi, 205
I-20099 Sesto San Giovanni MI(IT)

(74) Representative: Klunker . Schmitt-Nilson .
Hirsch
Winzererstrasse 106
D-8000 München 40(DE)

(54) **Process of making insulated- gate field-effect transistors.**

(57) Process of making insulated-gate field-effect transistors with junctions having an extremely low depth, comprising the steps of: forming a layer (18) of non-monocrystalline semiconductor material on a fixed area of a monocrystalline substrate in which are defined the source (20) and drain (21) regions of an insulated-gate field-effect transistor, and subsequent implantation of a doping agent into the layer of non-monocrystalline material (18). According to this process, a thermal oxidation is then carried out in order to convert the layer (18) into oxide and to transfer the implanted dopant into the substrate. Thus, one obtains heavily doped regions (20) and (21), self-aligned with the gate electrode, capable of forming the source and drain regions of the transistor.

FIG. 8

## PROCESS OF MAKING INSULATED-GATE FIELD-EFFECT TRANSISTORS

The instant invention relates to insulated-gate field-effect transistors (IGFETs) of the MOS (Metal-Oxide Semiconductor) type and, more particularly, to a process of making IGFETs with a high speed of response in integrated circuits with a high density of integration.

In order to obtain a high density of integration and a high speed of response, one must reduce the physical dimensions of the IGFET (Scaling Principle). In particular, it is necessary to lower the depth of the drain and source junctions in the substrate. Nowadays, it is possible to obtain N$^+$/P junctions having greatly reduced depth (of the order of 100-200 nm) by implanting arsenic, then recrystallizing the layer that has been subjected to implantation.

Conversely, for P$^+$/N junctions, it is difficult to go below 400 nm of junction depth. In fact, P$^+$/N junctions obtained by implanting boron to the lowest possible energy onto the implantation agents presently available have depts of approximately 400-500 nm because of the "channeling tail", which is a characteristic feature of boron implantation due to the canalizing of the ion implanted into the crystal and which produces an actual implantation depth greater than that desired.

This means that in CMOS processes, the gate of the transistor with P channel cannot go below certain dimensions.

There are several alternatives for overcoming this problem. One option is the implantation of BF$_2$ instead of boron. This enables one to obtain thinner P layers, but does not by any means eliminate the "channeling tail" problem and introduces into the substrate the kind of fluorine that may reduce the efficacy of the operations for making up for the crystallographic damage resulting from implantation. Another option is the implantation of boron into silicon made effectively amorphous. This eliminates the "channeling tail" problem, but poses other problems associated with the amorphous-making process. It is also possible to implant boron across an oxide layer: but this will inevitably introduce into the substrate oxygen atoms, the presence of which may reduce the efficacy of the operations aimed at making up for the crystallographic damage resulting from implantation; moreover, the presence of oxygen leads to a variety of other problems known to those skilled in the art.

P$^+$/N junctions with an extremely low depth can in reality be obtained through selective submicrometrc epitaxy, but this is a process that requires the use of extremely expensive equipment.

The object of the present invention is to provide a process for making MOS-type insulated-gate field-effect transistors with dimensions that are smaller than those achieved with conventional methods, and which does not call for the use of equipment other than that normally employed in a process of the MOS type.

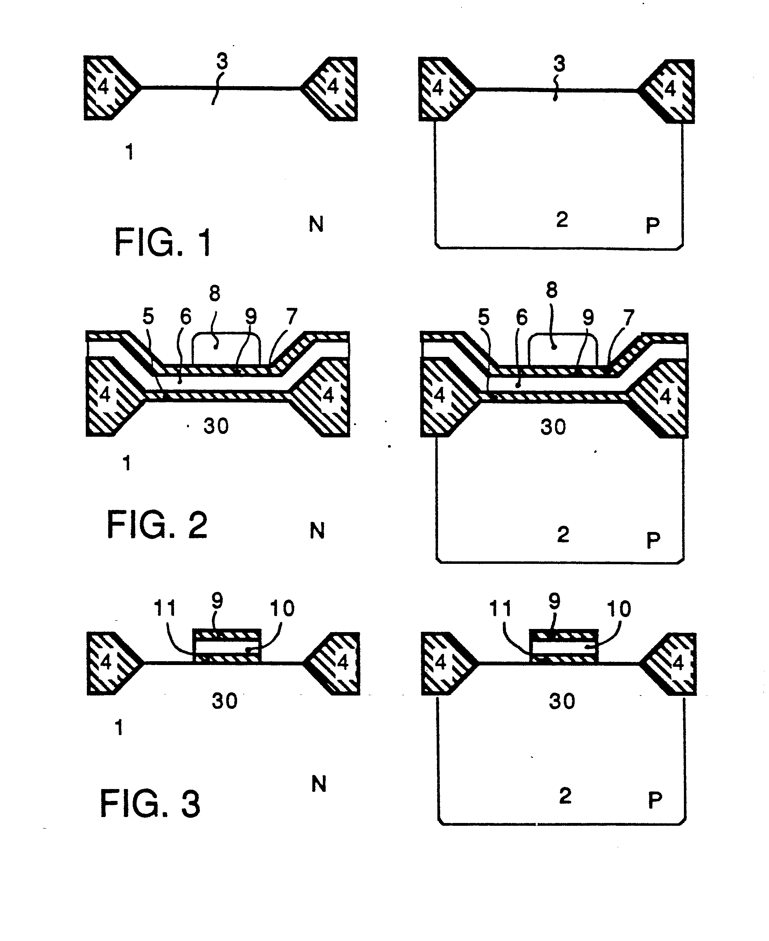

This object is achieved with the process defined and characterized in the accompanying claim 1 and can be further developed in accordance with the further claims. The invention is now illustrated by way of an embodiment shown in the accompanying drawings, in which Figures 1, 2, 3, 4, 5, 6, 7 and 8 show a greatly enlarged vertical section through a pair of complementary IGFET tansistors during several phases of a process incorporating the invention for fabricating the same.

A CMOS process has been selected in which the invention is solely concerned with the production of transistors with a P channel, because in this embodiment are obtained the major advantages of the process, but the invention can also be used directly for making transistors with an N channel.

The initial structure, shown in Figure 1, is achieved with operations well-known to the skilled artisan and comprises a substrate 1 consisting of a single silicon crystal doped with N-type impurities with a low concentration (of the order of 10$^{15}$ atoms/cm$^3$). In the substrate is limited a region 2 doped with P-type impurities, likewise of low concentration, called "P-well." Alternatively, the substrate can be of the P type, in which has been limited an N-type region, called "N-well". In substrate 1 and in region 2 are limited fixed areas 3 for the active zones designed to receive complementary IGFETs. In the remainder of its surface, the substrate is covered with a silicon dioxide layer (SiO2), which forms a "field" dielectric capable of insulating any active zone from other zones.

The following steps are carried out one after the other on the structure described above, reference being made to Figure 2:
-thermal oxidation, at a temperature of approximately 100°C of the uncovered surface of substrate 1 in order to form a silicon dioxide layer 5 approximately 300 nm thick, capable of forming the gate dielectric of the final transistor;
-deposition from silane (SiH$_4$) of a polycrystalline silicon layer 6, about 500 nm thick. The deposition is carried out by Chemical Vapor Deposition (CVD) technique at a temperature of around 600° C;
-doping of the polycrystalline silicon layer 6 by preliminary deposition of phosphorus oxychlorine (POCl$_3$) at a temperature of approximately 920° C. The concentration of doping impurities (of the N type, e.g. phosphorus atoms) is of the order of $10^{20}$ atoms/cm$^3$;

-diffusion of the doping impurities into polycrystalline silicon layer 6 and growth of a thin silicon dioxide layer 7, several tens nm thick by exposure in an oxidizing environment at a temperature of ca. 1 000° C (this silicon dioxide layer grown on polycrystalline silicon facilitates the subsequent operation);

-formation, by photolitographic operations known from the prior art, of a photoresist mask 8, which protects a portion 9 of silicon dioxide layer 7. This mask limits a fixed gate area of the IGFET on region 30 of the substrate intended for the channel function of the transistor. Now, with reference to Figure 3:

-removal of the unprotected portions of layers 7, 6, 5 (in that order) by subsequent chemical or physical etching (e.g., "in plasma" etching) so as to limit a silicon dioxide portion 9, a polycrystalline silicon portion 10, an gate oxide portion 11 (limitation of the gate), superposed in said order between them in said fixed area.

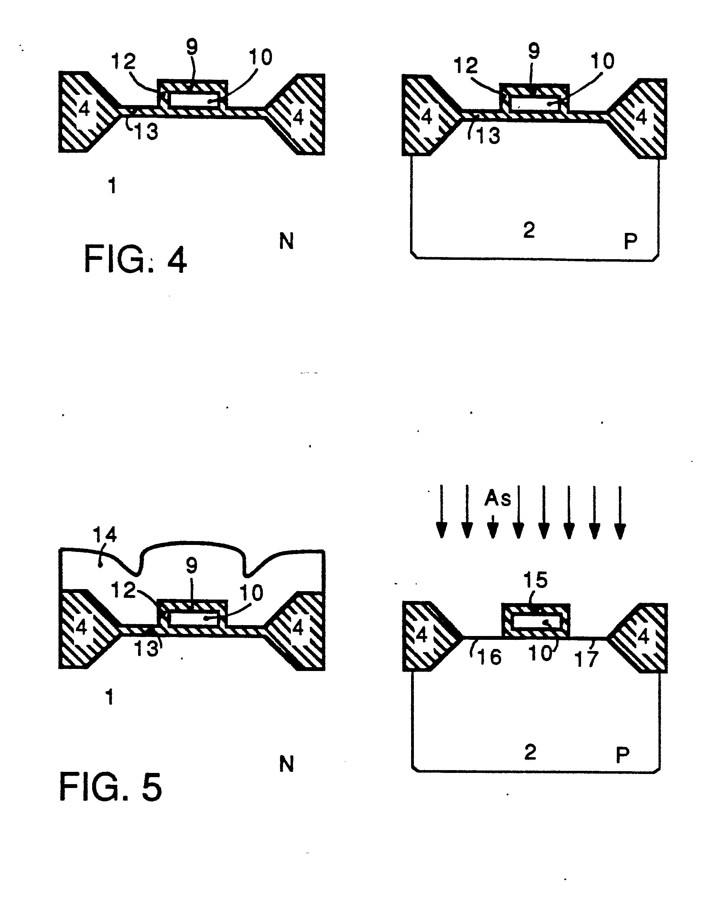

Now, with reference to, respectively, Figures 4, 5 and 6:

-thermal oxidation of the uncovered silicon surfaces: this oxidation is carried out at a relatively low temperature, around 800° C, in order to grow an oxide layer, the thickness of which depends on the concentration of doping impurities in the silicon; on the entire surface of portion 10 of polyrystalline silicon (including the edges), in which the dope concentration is around $10^{20}$ atoms/cm$^3$, can thus grow a silicon dioxide layer 12 about 150 nm thick, while on the uncovered area of substrate 1, in which the dope concentration is around $10^{15}$ atoms/cm$^3$, grows a silicon dioxide layer 13, about 35 nm thick;

- formation, by means of photolitographic operations known from the prior art, of a photoresist mask 14 which protects the region corresponding to the zone intended for the transistor with a P channel;

-etching of the silicon oxide in order to fully remove layer 13, uncovering the surface of substrate 1, where the oxide layer is thinner (e.g., diluted hydrofluoric acid). This etching does not uncover portion 10 of polycrystalline silicon, since it is covered with a much thicker oxide; portion 10 of polycrystalline silicon which forms the gate electrode of the IGFET is thus completely surrounded by silicon dioxide (Figure 5); the thickness of field oxide 4 does not undergo a significant reduction;

-ion implantation of N-type doping impurities, e.g., arsenic (As) in regions 16 and 17 underlying the areas of the substrate uncovered by the previous etching: this operation results in the formation of the n$^+$ source and drain regions of the transistor with an N channel.

The energy of implantation must be low in order to have a modest penetration of the doping agent into silicon; the dose of implanted doping impurities is very high, around $5 \bullet 10^{15}$/cm$^2$, in order to achieve high conductivity;

-removal of the residual photoresist;

-thermal treatment (annealing) at a moderate temperature in order to cause the substrate to recrystallize in the zone of implantation.

The prior art steps described above are followed by the steps taught by the invention listed below:

-deposition of a layer 18 having a fixed thickness of non-monocrystalline (i.e., polycrystalline or amorphous) silicon carried out, for example, by the CVD technique, or by the deposition technique known as sputtering;

-oxidation of layer 18 of non-monocrystalline silicon by exposure in an oxidizing environment at a moderate temperature: the growth of a thin layer of oxide (a few tens of nm) is achieved, which facilitates the subsequent masking;

-formation, by means of photolitographic operations known from the prior art, of a photoresist mask 19, which protects the region corresponding to the transistor with an N channel;

-etching the part not protected by the oxide grown on the non-monocrystalline silicon;

-ion implantation of P-type doping impurities, e.g., boron (B) in the not protected portion of layer 18. The dose of implanted doping impurities is very high, around $5 \bullet 10^{15}$ atoms/cm$^2$, in order to achieve high conductivity;

-removal of the residual photoresist;

-exposure in an oxidising environment at low temperature (700-900° C), long enough to fully convert the non-monocrystalline silicon into an oxide. During this phase, a part of the doping agent implanted in the preceding phase will be transferred into the underlying silicon, forming the source and drain regions 20 and 21 of the transistor; however, a part will remain trapped in the oxide. This must be taken into account when defining the implantation dose. The oxidation must be such as not to cause an excessive amount of the doping agent to diffuse into the substrate. However, note that precisely the presence of the polycrystalline silicon prevents an undesirable effect of increasing the diffusivity due to this oxidation.

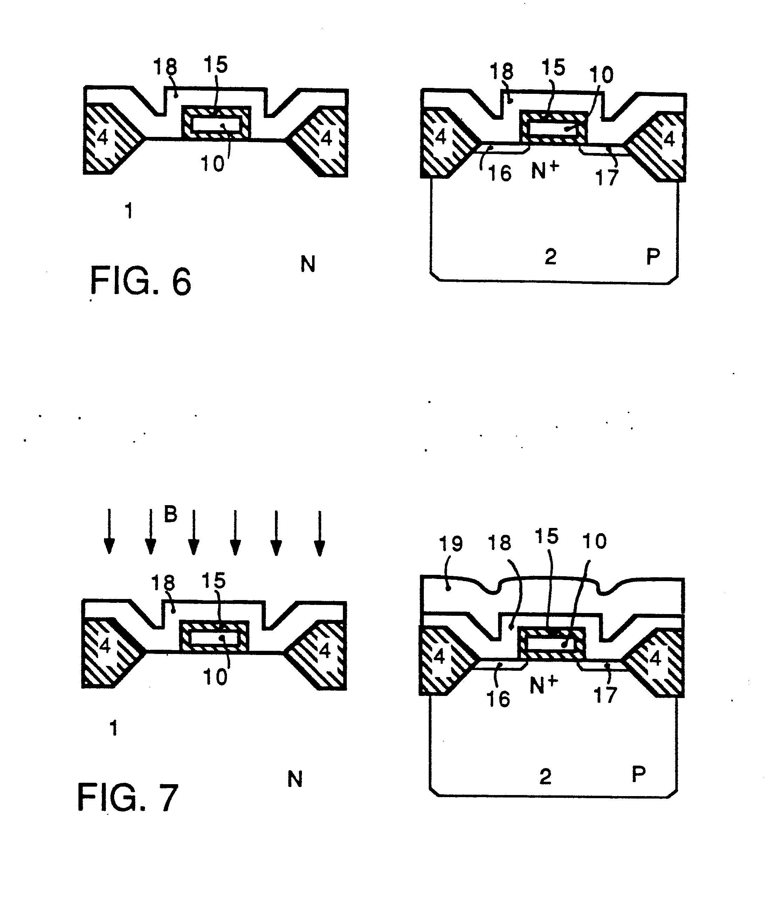

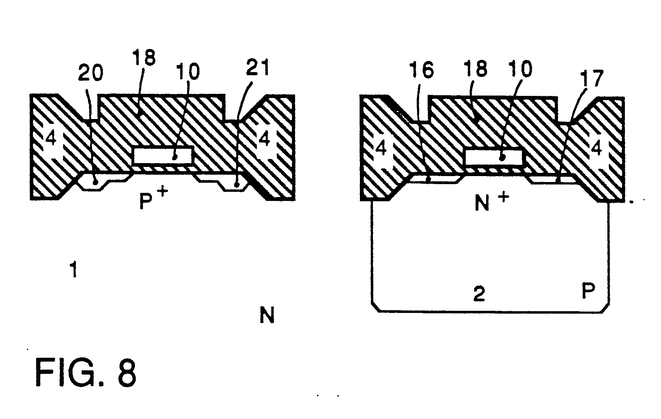

-The above operations are followed by the customary operations for opening the windows in the oxide for the gate, source and drain contacts in order to form the respective electrodes and, finally, in order to passivy the apparatus. In a process incorporating the invention, the polycrystalline silicon has the object of eliminating the channeling phenomenon, which is encountered when implanting boron into a monocrystalline substrate. In this way, the depth of the $P^+$/N junction can be drastically reduced, giving rise to an increase of the length of the channel. The depth of the $P^+$/N junction will be smaller where the implanted ions must traverse a greater thickness of polycrystalline silicon, i.e., at the edges of the gate region (Figure 7). As shown in Figure 8, this causes the polycrystalline silicon layer to behave like a spacer between the gate region and the source and drain regions: in this way, the superposition between the gate region and the $P^+$ regions can be reduced at will, thereby reducing the gate-source and gate-drain coupling capacities; this enables one to obtain high speeds of response of the transistor. Because the $P^+$ regions extend very little below the gate, the effective length of the transistor increases and reduces the punch-through risk.

The part of the process described as a sequence to known operations can be replaced by a succession of other operations likewise known to those skilled in the art.

## Claims

1. A process for making an insulated-gate field-effect transistor on a first fixed area of a substrate (1) of semiconductor material, having a first type of conductivity, comprising the steps of:

-forming a first insulating layer (4) on at least one second fixed area of said substrate (1), completely enclosing said first fixed area,

-forming on a first region of said first fixed area a second insulating layer (5),

-forming on said second insulating layer a conducting layer (6) and on said conducting layer a third insulating layer (7), the second insulating layer (7) and the conducting layer (6) capable of building up, respectively, a gate dielectric and a gate electrode of the transistor, and

-forming insulating walls at least on the uncovered portions of the edges of the conducting layer,

-defining in said first fixed area regions not covered by any layer, separated from each other, and capable of producing source and drain regions of the transistor,

characterized by

-successive operations to form in the area of at least said first fixed area a layer of non-monocrystalline semiconductor material (18),

-introducing through ion implantation at least into a portion of the layer of non-monocrystalline semiconductor material (18) impurities capable of producing in said layer a second type of conductivity opposite to said type of conductivity, and

-a thermal oxidizing operation capable of converting at least a portion of the non-monocrystalline semiconductor material (18) into insulating material, and transferring into the regions (20, 21) capable of forming source and drain regions of the transistor at least a portion of the impurities introduced into the layer of non-monocrystalline semiconductor material (18).

2. The process as set forth in claim 1, characterized in that the non-monocrystalline semiconductor material (18) is polycrystalline silicon.

3. The process as set forth in claim 1, characterized in that the non-monocrystalline semiconductor material (18) is amorphous silicon.

0 265 958

FIG. 1

3

4   4

1   N

3

4   4

2   P

FIG. 2

5  6  8  9  7

4   4

30

1   N

5  6  8  9  7

4   4

30

2   P

FIG. 3

11  9  10

4   4

30

1   N

11  9  10

4   4

30

2   P

FIG. 4

N

P

FIG. 5

N

As

P

FIG. 6

FIG. 7

FIG. 8